(19) Europäisches Patentamt / European Patent Office / Office européen des brevets

(11) **EP 2 259 080 A1**

(12) **DEMANDE DE BREVET EUROPEEN**

(43) Date de publication:
**08.12.2010 Bulletin 2010/49**

(51) Int Cl.:
***G01R 31/36*** *(2006.01)*

(21) Numéro de dépôt: **10163733.8**

(22) Date de dépôt: **25.05.2010**

(84) Etats contractants désignés:
**AL AT BE BG CH CY CZ DE DK EE ES FI FR GB
GR HR HU IE IS IT LI LT LU LV MC MK MT NL NO
PL PT RO SE SI SK SM TR**
Etats d'extension désignés:
**BA ME RS**

(30) Priorité: **27.05.2009 FR 0953500**

(71) Demandeur: **Peugeot Citroën Automobiles SA
78140 Vélizy-Villacoublay (FR)**

(72) Inventeur: **Porcellato, Denis
78450 Chavenay (FR)**

(54) **Système et procédé de détermination de la perte de capacité d'une batterie**

(57) Ce système de détermination de la perte de capacité d'une batterie (2) est **caractérisé en ce qu'**il comporte des moyens de :
- établissement (16) de la caractéristique de la tension de repos après un temps (t) en fonction de l'état de charge de la batterie ;
- mémorisation (22) de courbes représentant la pente de la tension de repos après un temps (t) de la batterie (2) en fonction de sa perte de capacité ;
- calcul (18) de la pente de ladite caractéristique ; et
- détermination (23) de la perte de capacité de la batterie (2) à partir de la pente calculée et de la courbe mémorisée.

FIG.1

EP 2 259 080 A1

**Description**

La présente invention concerne un système de détermination de la perte de capacité d'une batterie depuis la mise en service de ladite batterie.

Plus particulièrement, l'invention se rapporte à la détermination de l'énergie disponible à chaque instant, tout au long de la durée d'utilisation de la batterie, par l'estimation de la perte de capacité de la batterie.

Connaître la perte de capacité de la batterie permet de définir un état de charge réel, défini à partir d'une capacité réelle intégrant la perte de capacité de la batterie avec le vieillissement.

Connaître la perte de capacité de la batterie, permet également de définir un « état de santé » SOH (« State of Health » en anglais). Généralement, une batterie est considérée en fin de vie, lorsqu'elle a perdu 30% de sa capacité initiale.

L'invention concerne plus particulièrement les batteries de traction électriques utilisées dans les véhicules notamment électriques et hybrides pour lesquels il est indispensable de mettre en oeuvre une gestion intelligente de l'énergie électrique.

L'évolution de l'énergie d'une batterie est directement liée à sa perte de capacité au cours du temps. Elle dépend ainsi directement du degré de vieillissement de la batterie. Ce dernier est propre à chaque utilisation du véhicule c'est-à-dire à l'historique de chaque batterie montée à bord du véhicule.

Classiquement, la loi de variation du degré de vieillissement de la batterie est estimée à partir d'essais de vieillissement effectués sur un banc selon un profil de mission bien particulier.

Par conséquent, ces essais ne permettent généralement pas de déterminer le degré de vieillissement de la batterie précisément pour chaque véhicule, puisque chaque batterie a son propre historique en termes de sollicitations en courant et en température.

On conçoit que ceci représente un inconvénient pour une détermination précise de la perte de capacité de la batterie et de son énergie disponible à tout moment.

Le but de l'invention est de résoudre ce problème.

Plus particulièrement, l'invention vise à déterminer la perte de capacité d'une batterie, à tout moment, en prenant en compte le vieillissement de la batterie et son propre historique.

L'invention vise également à fournir une solution destinée à être embarquée sur un véhicule et peu coûteuse afin d'estimer l'énergie disponible de la batterie à tout instant.

A cet effet, l'invention a pour objet un système de détermination de la perte de capacité d'une batterie depuis sa mise en service comportant : des moyens de mesure de la température de la batterie ; des moyens d'établissement de la caractéristique de la tension de repos après un temps t en fonction de l'état de charge de la batterie à la température mesurée ; des moyens de mémorisation de courbes représentant, dans une plage de tension de fonctionnement, la pente de la tension de repos après un temps t de la batterie en fonction de sa perte de capacité à différentes températures ; des moyens de calcul de la pente de la caractéristique ; et des moyens de détermination de la perte de capacité de la batterie à partir de la pente calculée par les moyens de calcul et de la courbe mémorisée dans les moyens de mémorisation représentant la pente de la tension de repos après un temps t de la batterie en fonction de sa perte de capacité, à la température mesurée par les moyens de mesure.

L'invention a également pour objet un procédé de détermination de la perte de capacité d'une batterie depuis sa mise en service, comportant : une étape préalable de détermination de la pente de la tension de repos après un temps t de la batterie en fonction de son état de charge pour différents états de vieillissement de la batterie à différentes températures ; une étape préalable de mémorisation de courbes représentant, dans une plage de tension de fonctionnement définie, la pente de la tension de repos après un temps t de la batterie en fonction de sa perte de capacité, à différentes températures ; une étape de mesure de la température de la batterie ; une étape de calcul de la pente d'une caractéristique donnant, à la température mesurée, la tension de repos après un temps t en fonction de l'état de charge de la batterie ; et une étape de détermination de la perte de capacité de la batterie à partir de la pente calculée et de la courbe représentant la pente de la tension de repos après un temps t de la batterie en fonction de sa perte de capacité, à la température mesurée.

Suivant des modes particuliers de réalisation, le procédé comporte une ou plusieurs des caractéristiques suivantes, prise(s) isolément ou suivant toutes les combinaisons techniquement possibles :

- l'étape de calcul de la pente d'une caractéristique comprend une étape d'obtention d'au moins un point de mesure associant à une tension de repos mesurée un état de charge mesurée, l'étape d'obtention d'un point de mesure comportant les étapes élémentaires suivantes : une étape de mesure du courant traversant la batterie ; une étape d'intégration du courant traversant la batterie depuis le dernier recalage de l'état de charge de la batterie ; une étape de calcul de l'état de charge de la batterie à partir de l'intégration du courant ; et une étape de mesure de la tension de repos après un temps t de la batterie à la température mesurée.
- après obtention d'un premier point de mesure, les étapes élémentaires de mesure sont réitérées de manière à obtenir un second point de mesure, la pente calculée étant la pente de la droite passant par les premier et second points de mesure.

- le point de mesure est reporté sur un abaque regroupant, pour la température mesurée, une pluralité de caractéristiques donnant la tension de repos après un temps t en fonction de l'état de charge de la batterie, et la pente calculée est la pente de la caractéristique de l'abaque sur laquelle est placé le point de mesure.
- la batterie est une batterie électrochimique.
- la batterie est choisie parmi le groupe comportant des batteries de type Li-ion, NiMH, Ni-Zn, Plomb acide.
- la plage de tension de fonctionnement définie est associée à une gamme utile d'état de charge de la batterie comprise entre 20 % et 100 %, de préférence entre 20 % et 80 %.

On va maintenant décrire des modes de réalisation de l'invention de façon plus précise mais non limitative en regard des dessins annexés, sur lesquels :

- la figure 1 est un schéma synoptique illustrant la structure d'un système de détermination selon l'invention ;
- la figure 2 est constituée de courbes illustrant le principe de la détermination mise en oeuvre selon l'invention ;
- la figure 3 est constituée d'une courbe illustrant le fonctionnement du système de détermination selon l'invention; et
- la figure 4 est un organigramme illustrant le fonctionnement du système de détermination selon l'invention.

Le système selon l'invention détermine la perte de capacité d'une batterie grâce à une mesure de la tension de repos, mesurée à un temps t après le début de la phase de repos durant laquelle l'intensité du courant qui traverse la batterie est nulle. La tension de repos après un temps t est mesurée à un certain état de charge de la batterie.

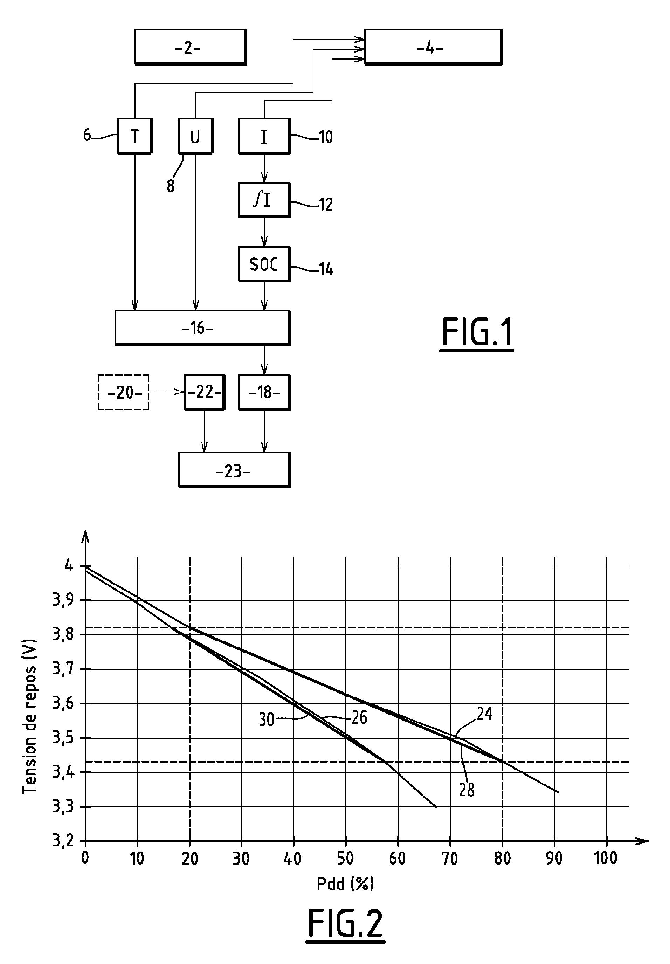

On a illustré sur la figure 1 un schéma synoptique d'un tel système qui représente un mode de réalisation du diagnostic de la batterie pour déterminer sa perte de capacité selon l'invention.

Une telle batterie est désignée par la référence générale 2. La gestion de cette batterie est assurée par un superviseur de la batterie désigné par la référence générale 4.

La batterie 2 est associée à des moyens de mesure de la température de la batterie 2 désignés par la référence générale 6, à des moyens de mesure de la tension de repos après un temps t de la batterie 2 désignés par la référence 8 et à des moyens de mesure du courant traversant la batterie 2 désignés par la référence 10.

La sortie des moyens de mesure de courant 10 est reliée à des moyens d'intégration 12 du courant traversant la batterie 2 depuis le dernier recalage de son état de charge. La sortie de ces moyens d'intégration 12 est reliée à des moyens de calcul d'un état de charge noté SOC de la batterie 2 et désignés par la référence générale 14.

Les sorties des moyens de mesure de température 6 et de tension de repos après un temps t 8 ainsi que des moyens de calcul 14 de l'état de charge SOC sont reliés à des moyens d'établissement 16 de la caractéristique de la tension de repos après un temps t en fonction de l'état de charge SOC à la température mesurée.

Des moyens de calcul 18 de la pente de cette caractéristique sont également prévus.

La référence 20 désigne des moyens 20 de détermination expérimentale sur banc de la pente de la tension de repos après un temps t de la batterie 2 en fonction de son état de charge pour différents états de vieillissement de la batterie 2 pour différentes températures.

Ces moyens de détermination 20 de la pente sur banc ne font pas partie du système monté sur véhicule, mais permettent de générer des courbes représentant la pente de la tension de repos après un temps t de la batterie en fonction de la perte de capacité à différentes températures, courbes qui sont stockées dans des moyens de mémorisation 22.

Les moyens de mémorisation 22 de courbes et les moyens de calcul 18 de la pente sont reliés à des moyens de détermination 23 de la perte de capacité de la batterie 2.

Il convient également de noter que les moyens de mesure de température 6, de la tension de repos après un temps t 8 et de courant 10 sont reliés au superviseur 4 de la batterie 2 pour lui permettre de gérer l'état de charge et la thermique de la batterie 2 notamment en veillant à ce que la température et l'état de charge restent compris dans les limites permises par le constructeur de la batterie 2.

Sur la figure 2, sont représentées deux courbes 24 et 26 correspondant respectivement à une batterie neuve et à une batterie usagée par exemple de type lithium qui permet d'illustrer le principe de détermination de la perte de capacité, selon l'invention.

Les courbes 24 et 26 représentent la tension de repos après un temps t exprimée en volts respectivement de la batterie neuve et usagée en fonction de son état de charge, ou plus précisément en fonction de sa profondeur de décharge exprimée en %. La profondeur de décharge d'une batterie est notée Pdd. Elle est reliée à l'état de charge de la batterie noté SOC selon la relation :

$$Pdd = (100-SOC)\ \% \hspace{4cm} (1)$$

Dans la suite de la description, les notions d'état de charge et de profondeur de décharge seront utilisées pour définir un même concept étant donné la relation directe qui les lie.

Plus précisément, l'état de charge SOC à l'instant t est calculé par les moyens 14 selon par exemple la relation :

$$SOC(t) \square (SOC_0 - (\int \frac{I}{C_{nom}} dt)*100)$$

où $SOC_0$ est l'état de charge connu à l'instant initial t = 0, instant auquel s'est opéré le recalage, $C_{nom}$ est la capacité nominale de la batterie fournie par le constructeur et $\int I$ est la quantité d'électricité qui a traversé la batterie pendant la durée t et mesurée par les moyens 12. En variante, certaines technologies de batteries, la notion de rendement p est introduite dans la formule précédente qui devient alors :

$$SOC(t) \square (SOC_0 - (\int \frac{\square I}{C_{nom}} dt)*100)$$

Il convient de noter que l'état de charge SOC calculé de cette manière ne prend pas en compte le vieillissement de la batterie et n'est donc pas son état de charge réel.

La courbe 24 correspond à une température de 40° C. Elle est obtenue à partir d'essais de vieillissement sur banc. Elle représente la tension de repos après un temps t égal à une heure en fonction de l'état de charge de la batterie 2 avant sa mise en service.

La courbe 26 correspond également à une température de 40° C et elle est également obtenue à partir d'essais de vieillissement sur banc. Elle représente la tension de repos après un temps égal à une heure en fonction de l'état de charge de la batterie 2 après environ 62000 $\mu$ cycles d'utilisation.

Sur la figure 2, deux courbes 28 et 30 sont également représentées. Elles correspondent respectivement aux courbes 24 et 26 linéarisées sur une plage de tension de fonctionnement définie, correspondant ici à un état de charge compris entre 20 % et 80 %.

La plage de linéarisation [20%, 80%] est ici prise comme exemple. Elle correspond très souvent à la plage de fonctionnement de la batterie pour un véhicule complètement hybride (« Full Hybrid vehicle »).

D'autres plages de linéarisation peuvent être définies notamment selon l'application souhaitée : Véhicule Electrique ou Véhicule Hybride. En effet, la plage de fonctionnement d'une batterie d'un Véhicule Electrique ou d'un véhicule Hybride rechargeable (« plug-in hybrid ») est communément de [20%, 100%].

La plage d'état de charge compris entre 20 % et 80 % correspond, dans la figure 2, à une tension au repos après une heure comprise entre 3,43 V et 3,83 V, cet intervalle étant défini à partir des points d'intersection de la courbe 24 avec les lignes verticales correspondant à Pdd = 20 % et Pdd = 80 %.

Le principe de l'invention est relié, au fait constaté expérimentalement à partir des essais de vieillissement sur banc, que la pente de la caractéristique tension au repos après un temps t en fonction de la profondeur de décharge est d'autant plus pentue que la batterie est vieille.

Ceci apparaît clairement sur la figure 2. En effet, la pente de la courbe 30 est plus élevée que celle de la courbe 28.

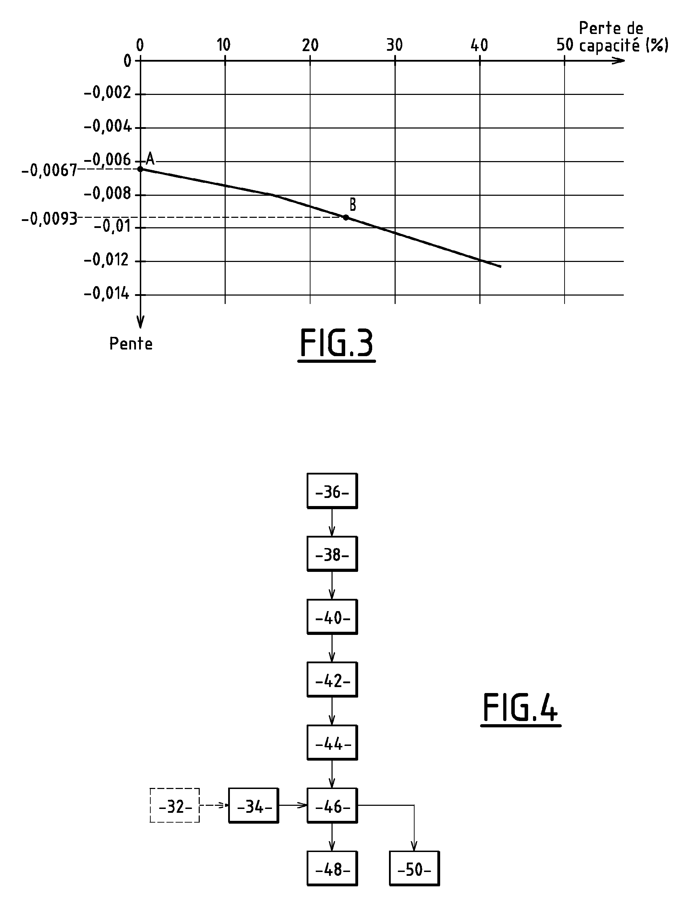

La figure 3 représente la pente de la tension de repos après une heure en fonction de la perte de capacité de la batterie à une température de 40° C.

Cette courbe est obtenue à partir des moyens de mémorisation 22. Les points A et B correspondent respectivement aux courbes 24 et 26 de la figure 2.

Ainsi, la connaissance de la pente de la caractéristique de la tension de repos après un temps t en fonction de l'état de charge de la batterie à la température de 40° C, permet d'obtenir sa perte de capacité grâce à une lecture sur la courbe de la figure 3.

La structure du système selon l'invention ainsi que le principe de ce système, pour déterminer la perte de capacité d'une batterie grâce à un calcul de la pente de la caractéristique de la tension de repos après un temps t en fonction de l'état de charge ayant été décrits, le fonctionnement de ce système est détaillé dans la suite de la description en référence à la figure 4.

A une étape préalable 32, la pente de la tension de repos après un temps t de la batterie en fonction de son état de charge, est déterminée expérimentalement sur banc par les moyens de détermination 20 pour différents états de vieillissement de la batterie 2 et à différentes températures.

A l'étape préalable 34, des courbes représentant, dans une plage de fonctionnement définie, la pente déterminée en 32 en fonction de la perte de capacité de la batterie 2 à différentes températures, sont mémorisées dans les moyens de mémorisation 22.

Les étapes préalables 32 et 34 sont menées lors d'essais sur banc alors que les étapes décrites ci-après sont menées sur véhicule.

A l'étape 36, la température, la tension de repos après un temps t et le courant de la batterie 2 sont mesurés à l'aide des moyens 6, 8 et 10 respectivement.

En 38, les moyens d'intégration 12 intègrent le courant traversant la batterie 2 depuis le dernier recalage de l'état de charge en utilisant la mesure du courant effectuée à l'étape 36 par les moyens de mesure de courant 10.

En 40, les moyens de calcul 14 de l'état de charge SOC de la batterie 2 à la température mesurée en 36 calculent l'état de charge SOC à partir de l'intégration de courant effectuée à l'étape 38, de $SOC_0$ et de Cnom.

En 42, après obtention d'un premier point de mesure associant une tension de repos mesurée à un état de charge mesuré, les étapes de mesure 36 à 40 sont réitérées à un moment ultérieur de manière à obtenir un second point de mesure. De préférence, les étapes de mesure sont réitérées moins d'une semaine après les mesures effectuées en 36 à 40. Si les températures mesurées en 36 et en 42 sont suffisamment proches, c'est-à-dire que la différence des deux températures est inférieure à un seuil déterminé et que les états de charge calculés en 40 et 42 sont suffisamment éloignés, les moyens de calcul 18 de pente calculent, en 44, la pente à partir de ces deux points de mesures comme étant la différence des tensions de repos après un temps t mesurées en 36 et en 42, divisée par la différence des états de charge calculés en 40 et 42.

En 46, la perte de capacité de la batterie est déterminée à partir de la pente calculée en 44 et de la courbe mémorisée en 34 correspondant à la température mesurée en 36.

Cette détermination de la perte de capacité permet de déterminer, en 48 l'état de santé SOH (« State of Health ») de la batterie 2 depuis son début de vie.

La connaissance de la perte de capacités permet également de déterminer en 50 la valeur de l'état de charge réel de la batterie, c'est-à-dire calculé en fonction de la capacité réelle de la batterie et non pas en fonction de la capacité nominale.

Avantageusement, avant de prendre en compte la perte de capacité pour déterminer l'état de charge réel ou l'état de santé SOH de la batterie 2, on fera plusieurs itérations de la mesure de la perte de capacité afin de confirmer réellement cette perte.

Ainsi, le système selon l'invention permet à partir du calcul de la pente de la caractéristique de la tension de repos après un temps t aux bornes de la batterie en fonction de son état de charge de déterminer la perte de capacité de la batterie et son énergie disponible.

Ce système, en plus de prendre en compte le vieillissement de la batterie, présente l'intérêt d'être peu coûteux et simple à mettre en oeuvre sur un véhicule car il utilise des composants qui sont les capteurs de tension, de courant et de température déjà existants.

Un tel système peut être embarqué ou non, ce qui permet d'avoir des mesures en mode roulage ou en mode parking pour un diagnostic de l'énergie disponible dans la batterie.

Bien entendu, d'autres modes de réalisation encore peuvent être envisagés.

Par exemple, à une température donnée, différentes courbes expérimentales reliant la tension de repos (ou f.e.m.) à la profondeur de décharge Pdd (ou de l'état de charge SOC), telles que les courbes 24 et 26 de la Figure 3, sont obtenues sur banc. Ces courbes expérimentales sont ensuite stockées dans les moyens de mémorisation 22 pour constituer un abaque. Plusieurs abaques correspondant chacun à une température différente sont ainsi mémorisés.

Puis, au cours de l'utilisation du véhicule, on effectue une mesure de la température, de la tension de repos et de la SOC. On reporte l'unique point de mesure (Fem, SOC) sur l'abaque associé à la température mesurée. La courbe expérimentale sur laquelle est positionné cet unique point de mesure possède une pente connue. Cette pente, dite « pente calculée », est utilisée pour déterminer, à partir de la courbe de la Figure 4, la perte de capacité de la batterie.

Ce mode de réalisation permet d'éviter les contraintes liées à la détermination de la pente de la courbe au moyen de deux points de mesure (Fem, SOC) « suffisamment » rapprochés dans le temps.

Cette variante de réalisation convient d'autant mieux à un véhicule électrique ou à un véhicule hybride rechargeable, qu'elle permet un recalage absolu de l'état de charge en fin de charge de la Batterie : SOC = 100% en fin de charge de la batterie.

**Revendications**

1. Système de détermination de la perte de capacité d'une batterie (2) depuis la mise en service de ladite batterie (2), **caractérisé en ce qu'**il comporte :

   - des moyens de mesure (6) de la température de la batterie (2) ;
   - des moyens d'établissement (16) de la caractéristique de la tension de repos après un temps t en fonction de l'état de charge de la batterie (2) à la température mesurée ;
   - des moyens de mémorisation (22) de courbes représentant, dans une plage de tension de fonctionnement, la pente de la tension de repos après un temps t de la batterie (2) en fonction de sa perte de capacité à différentes températures ;
   - des moyens de calcul (18) de la pente de ladite caractéristique ; et
   - des moyens de détermination (23) de la perte de capacité de la batterie (2) à partir de la pente calculée par les moyens de calcul (18) et de la courbe mémorisée dans lesdits moyens de mémorisation (22) représentant la pente de la tension de repos après un temps t de la batterie en fonction de sa perte de capacité, à la température mesurée par lesdits moyens de mesure (6).

2. Procédé de détermination de la perte de capacité d'une batterie (2) depuis la mise en service de ladite batterie (2), **caractérisé en ce qu'**il comporte :

   - une étape préalable de détermination (32) de la pente de la tension de repos après un temps t de la batterie (2) en fonction de son état de charge pour différents états de vieillissement de la batterie (2) à différentes températures ;
   - une étape préalable de mémorisation (34) de courbes représentant, dans une plage de tension de fonctionnement définie, la pente de la tension de repos après un temps t de la batterie (2) en fonction de sa perte de capacité, à différentes températures ;
   - une étape de mesure (36) de la température de la batterie (2) ;
   - une étape de calcul (44) de la pente d'une caractéristique donnant, à la température mesurée, la tension de repos après un temps t en fonction de l'état de charge de la batterie (2) ; et,
   - une étape de détermination (46) de la perte de capacité de la batterie (2) à partir de la pente calculée et de la courbe représentant la pente de la tension de repos après un temps t de la batterie (2) en fonction de sa perte de capacité, à la température mesurée.

3. Procédé selon la revendication 2, **caractérisé en ce que** l'étape de calcul de la pente d'une caractéristique comprend une étape d'obtention d'au moins un point de mesure associant à une tension de repos mesurée un état de charge mesurée, ladite étape d'obtention d'un point de mesure mettant comportant les étapes élémentaires suivantes :

   - une étape de mesure (36) du courant traversant la batterie (2) ;
   - une étape d'intégration (38) du courant traversant la batterie (2) depuis le dernier recalage de l'état de charge de la batterie (2);
   - une étape de calcul (40) de l'état de charge de la batterie à partir de l'intégration du courant ; et
   - une étape de mesure (36) de la tension de repos après un temps t de la batterie à la température mesurée à l'état de charge calculé.

4. Procédé selon la revendication 3, **caractérisé en ce que** après obtention d'un premier point de mesure, les étapes élémentaires de mesure sont réitérées de manière à obtenir un second point de mesure, ladite pente calculée étant la pente de la droite passant par lesdits premier et second points de mesure.

5. Procédé selon la revendication 3, **caractérisé en ce que** le point de mesure est reporté sur un abaque regroupant, pour ladite température mesurée, une pluralité de caractéristiques donnant la tension de repos après un temps t en fonction de l'état de charge de la batterie (2), et **en ce que** ladite pente calculée est la pente de la caractéristique de l'abaque sur laquelle est placé ledit point de mesure.

6. Procédé selon l'une quelconque des revendications 2 à 5, **caractérisé en ce que** la batterie (2) est une batterie électrochimique.

7. Procédé selon la revendication 6, **caractérisé en ce que** la batterie (2) est choisie parmi le groupe comportant des batteries de type Li-ion, NiMH, Ni-Zn, Plomb acide.

8. Procédé selon l'une quelconque des revendications 2 à 7, **caractérisé en ce que** la plage de tension de fonctionnement définie est associée à une gamme utile d'état de charge de la batterie comprise entre 20 % et 100 %, de préférence entre 20 % et 80 %.

FIG.1

FIG.2

FIG.3

FIG.4

Europäisches
Patentamt

European
Patent Office

Office européen
des brevets

**RAPPORT DE RECHERCHE EUROPEENNE**

Numéro de la demande

EP 10 16 3733

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | EP 0 864 876 A1 (OMRON TATEISI ELECTRONICS CO [JP]) 16 septembre 1998 (1998-09-16)<br>* abrégé; figures 2,9 *<br>----- | 1,2 | INV.<br>G01R31/36 |
| A | DE 10 2007 023901 A1 (DAIMLER CHRYSLER AG [DE]) 27 novembre 2008 (2008-11-27)<br>* alinéas [0066] - [0071]; figure 3 *<br>----- | 1,2 | |
| A | US 2008/103709 A1 (YUN HAN-SEOK [KR] ET AL) 1 mai 2008 (2008-05-01)<br>* revendications 1-5,19; figures 1-4 *<br>----- | 1,2 | |

DOMAINES TECHNIQUES
RECHERCHES (IPC)

G01R

Le présent rapport a été établi pour toutes les revendications

| Lieu de la recherche | Date d'achèvement de la recherche | Examinateur |
|---|---|---|
| Munich | 30 août 2010 | Iwansson, Kaj |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

..............................................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 10 16 3733

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

30-08-2010

| Document brevet cité au rapport de recherche | Date de publication | Membre(s) de la famille de brevet(s) | Date de publication |
|---|---|---|---|
| EP 0864876 A1 | 16-09-1998 | JP 7325133 A | 12-12-1995 |
| DE 102007023901 A1 | 27-11-2008 | AUCUN | |
| US 2008103709 A1 | 01-05-2008 | KR 20080039655 A | 07-05-2008 |

EPO FORM P0460

Pour tout renseignement concernant cette annexe : voir Journal Officiel de l'Office européen des brevets, No.12/82